# EUROPEAN PATENT APPLICATION

(11) **EP 1 753 035 A1**
(43) Date of publication of application: **14.02.2007**
(21) Application number: 05736735.1
(22) Date of filing: 27.04.2005
(51) Int. Cl.: H01L 33/00

(54) **LIGHT-EMITTING DEVICE AND METHOD FOR MANUFACTURING SAME**

(30) Priority: 28.04.2004 JP 2004133131
(71) Applicant: MATSUSHITA ELECTRIC INDUSTRIAL CO., LTD., Osaka 571-8501 (JP)
(72) Inventor: OBARA, K., c/o Matsushita Elect. Indus. Co., Ltd., Chuo-ku, Osaka-shi, Osaka 540-6319 (JP); MAEDA, T., c/o Matsushita Elect. Indus. Co., Ltd., Chuo-ku, Osaka-shi, Osaka 540-6319 (JP); YANO, T., c/o Matsushita Elect. Indus. Co., Ltd., Chuo-ku, Osaka-shi, Osaka 540-6319 (JP); TANIMOTO,N., c/o Matsushita Elect. Indus. Co., Ltd, Chuo-ku, Osaka-shi, Osaka 540-6319 (JP)
(74) Representative: Grünecker, Kinkeldey, Stockmair & Schwanhäusser Anwaltssozietät
(86) International application number: PCT/JP2005/008027
(87) International publication number: WO 2005/106978

(57) **Abstract**

In a light emitting apparatus that includes a plurality of semiconductor light emitting devices 2 each having a light emitting face covered with a phosphor layer 3, a semiconductor assembly obtained by assembling a submount and the semiconductor light emitting devices is mounted on the substrate. Accordingly, chromaticity characteristics of the semiconductor assembly can be measured before the semiconductor assembly is mounted on the substrate. Therefore, even if using a plurality of semiconductor light emitting devices, a semiconductor assembly can be prepared on which the semiconductor light emitting devices each having uniform chromaticity characteristics are mounted before the semiconductor assembly is mounted on the substrate. And, a light emitting apparatus having suppressed dispersion of chromaticity can be manufactured.

## Description

### TECHNICAL FIELD

The present invention relates to a light emitting apparatus that includes a plurality of semiconductor light emitting devices each having a light emitting face, at least part of the light emitting face being covered with a phosphor layer, and a manufacturing method of the same.

### BACKGROUND ART

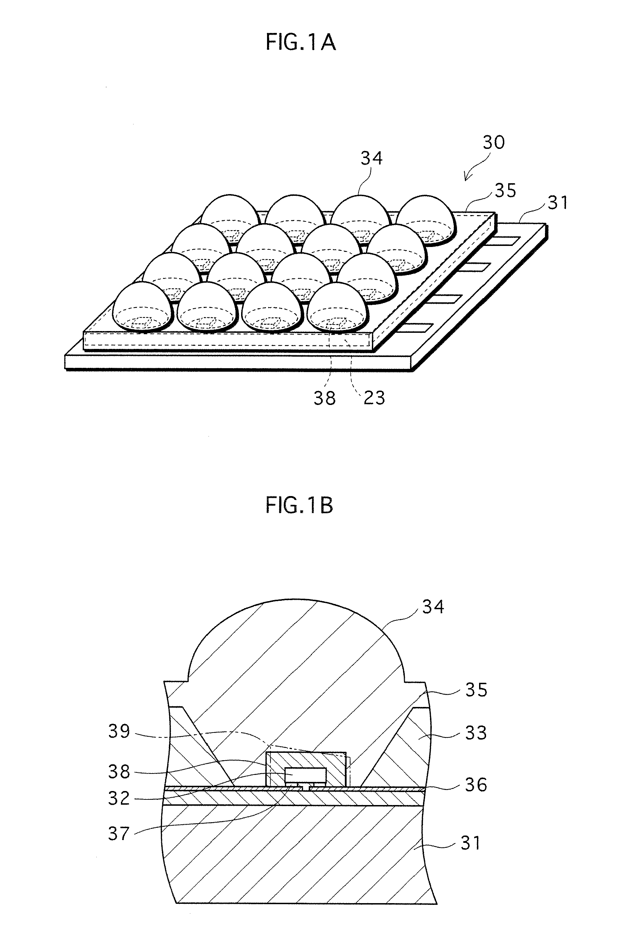

In conventional light emitting apparatuses, a plurality of semiconductor light emitting devices are mounted on a substrate, and each of the semiconductor light emitting devices is covered with a resin containing a phosphor. As one of such conventional light emitting apparatus, a light emitting apparatus is known that is disclosed in Japanese Patent Application Publication No. 2002-299694.
The following describes a structure of a conventional light emitting apparatus with reference to FIG. 1. FIG. 1 shows the conventional light emitting apparatus, where FIG. 1A is a perspective view, and FIG. 1B is a fragmentary enlarged sectional view. As shown in FIG. 1A and FIG. 1B, a conventional light emitting apparatus 30 includes a substrate 31, a plurality of semiconductor light emitting devices 32 that are flip-chip mounted on the substrate 31, a reflecting frame 33 having an opening in a position where each semiconductor light emitting device 32 is arranged on the substrate 31, and a resin layer 35 having a lens unit 34 formed thereon, the lens unit 34 being convex in a light emitting direction of the semiconductor light emitting device 32 and covering the reflecting frame 33.

As shown in FIG. 1B, the substrate 31 includes a wiring pattern 36, and is connected with the semiconductor light emitting device 32 via a bump electrode 37 that is a convex electrode formed in the semiconductor light emitting device 32.
The semiconductor light emitting device 32 is covered with a phosphor layer 38 made of a resin containing a phosphor. For example, if the semiconductor light emitting device 32 that emits blue light is covered with the phosphor layer 38 containing a phosphor that has a complementary color to blue, the lighting apparatus 30 emits white light.

After the semiconductor light emitting device 32 is flip-chip mounted on the substrate 31, the phosphor layer 38 is formed using a screen printing method.
With this structure, when blue light emitted from the semiconductor light emitting device 32 passes through the phosphor layer 38, the light emitting apparatus 30 is excited by a phosphor thereby to emit white light.

### DISCLOSURE OF THE INVENTION

### THE PROBLEMS THE INVENTION IS GOING TO SOLVE

However, in the case of the conventional light emitting apparatus shown in FIG. 1, it is difficult to form the phosphor layer 38 having a uniform thickness on each of the plurality of semiconductor light emitting devices 32 using the screen printing method. For example, as shown by a two-dot chain line 39 in FIG. 1B, a thickness is ununiform in the phosphor layer 38. A thicker portion of the phosphor layer 38 due to this dispersion has a higher wavelength conversion degree due to the phosphor than a thinned portion thereof. As a result, in the thicker portion, light emitted from the conventional light emitting apparatus emits intense green-yellow light, and thereby the light glows yellowish.

Therefore, chromaticity dispersion is observed in the light emitting apparatus.
Difference of chromaticity characteristics is basically observed in the semiconductor light emitting device 32. Therefore, even if the phosphor layer 38 having a uniform thickness can be formed, difference of chromaticity characteristics is observed due to dispersion of light emitting wavelengths.
In the conventional light emitting apparatus, the phosphor layer 38 is formed after the semiconductor light emitting devices 32 are mounted on the substrate 31. Therefore, chromaticity can be measured only after the light emitting apparatus is completed as a product. For example, supposed that a result of the chromaticity measurement shows that the semiconductor light emitting device 32 has undesired chromaticity characteristics. If the semiconductor light emitting device 32 is removed, the bump electrode 37 remains joined with the substrate 31. An alternative semiconductor light emitting device 32 cannot be mounted on the substrate 31 having the bump electrode 37 joined therewith. Therefore, the substrate 31 cannot be used as a product anymore.

In view of the above problem, the present invention aims to provide a light emitting apparatus having suppressed dispersion of chromaticity even if using a plurality of semiconductor light emitting devices each covered with a phosphor layer that converts wavelengths due to a phosphor, and a manufacturing method of the same.

### MEANS FOR SOLVING THE PROBLEM

A light emitting apparatus according to the present invention is a light emitting apparatus including: a plurality of semiconductor light emitting devices each having a light emitting face, at least part of the light emitting face is covered with a phosphor layer; one or more submounts; and a substrate, wherein each of the plurality of semiconductor light emitting devices is mounted on any one of the one or more submounts, and the one or more submounts are mounted on the substrate.
In another aspect of the light emitting apparatus according to the present invention, each of the one or more submounts is mounted on the substrate in assembled condition with at least one of the plurality of semiconductor light emitting devices.

In a specific aspect of the light emitting apparatus according to the present invention, the phosphor layer has at least one inclined face that connects a top face and one of lateral faces of the phosphor layer, and a minimum distance from the inclined face to the semiconductor light emitting device is substantially equal to a thickness of the phosphor layer.
In another specific aspect of the light emitting apparatus according to the present invention, the phosphor layer has at least one inclined lateral face, and a minimum distance from the inclined lateral face to the semiconductor light emitting device is substantially equal to a thickness of the phosphor layer.

In another specific aspect of the light emitting apparatus according to the present invention, the semiconductor assembly is mounted in a matrix arrangement, and a positional relation between the semiconductor light emitting device and a wire connection region of the submount in each semiconductor assembly is different from that in any adjoining semiconductor assembly in the matrix arrangement.
A method of manufacturing a light emitting apparatus according to the present invention is a method of manufacturing a light emitting apparatus including: a substrate, one or more submounts, and a plurality of semiconductor light emitting devices each having a light emitting face, at least part of the light emitting face being covered with a phosphor layer, the method comprising the steps of: mounting at least one of the plurality of semiconductor light emitting devices on each of the one or more submounts; assembling a semiconductor assembly by forming the phosphor layer so as to cover each of the semiconductor light emitting devices; selecting a plurality of semiconductor assemblies each having a predetermined chromaticity characteristic by measuring each chromaticity characteristic of the semiconductor assemblies; and mounting the selected plurality of semiconductor assemblies on the substrate.

In a specific aspect of the method of manufacturing the light emitting according to the present invention, in the step of mounting the selected one or more semiconductor assemblies on the substrate, the selected semiconductor assemblies are mounted on the substrate in a matrix arrangement such that a positional relation between the semiconductor light emitting device and a wire connection region of the submount in each semiconductor assembly is different from that in any adjoining semiconductor assembly in the matrix arrangement.

### EFFECT OF THE INVENTION

In a light emitting apparatus according to the present invention, each of one or more submounts is mounted on a substrate in assembled condition with at least one of a plurality of semiconductor light emitting devices. Accordingly, chromaticity characteristics of the semiconductor assembly can be measured before the semiconductor assembly is mounted on the substrate. Therefore, even if using a plurality of semiconductor light emitting devices, before mounting of the semiconductor assembly on the substrate, a semiconductor assembly can be prepared on which the semiconductor light emitting devices each having uniform chromaticity characteristics are mounted. And, a light emitting apparatus having suppressed dispersion of chromaticity can be manufactured.

Furthermore, if the phosphor layer that covers a light emitting face of each of the semiconductor light emitting devices has an inclined face that connects a top face and one of lateral faces of the phosphor layer, or if the phosphor layer that covers the light emitting face of the semiconductor light emitting device has an inclined lateral face, each distance light emitted from the semiconductor light emitting device passes through the phosphor layer can be substantially uniform. This allows preparation of a semiconductor assembly having less difference of chromaticity characteristics.

### BRIEF DESCRIPTION OF THE DRAWINGS

FIG. 1 shows a conventional light emitting apparatus, where FIG. 1A is a perspective view, and FIG. 1B is a fragmentary enlarged sectional view;
FIG. 2 is a perspective view of a light emitting apparatus according to a first embodiment of the present invention;
FIG. 3 is a fragmentary enlarged sectional view of the light emitting apparatus according to the first embodiment of the present invention;
FIG. 4 shows a structure of a semiconductor assembly used for the light emitting apparatus according to the first embodiment of the present invention, where FIG. 4A is a partially broken side view, and FIG. 4B is a plan view;
FIG. 5 shows a phosphor layer according to a first modification example, where FIG. 5A is a plan view, and FIG. 5B is a front view;
FIG. 6 shows a phosphor layer according to a second modification example, where FIG. 6A is a plan view, and FIG. 6B is a front view;
FIG. 7 shows a phosphor layer according to a third modification example, where FIG. 7A is a plan view, and FIG. 7B is a front view;
FIG. 8 shows a phosphor layer according to a fourth modification example, where FIG. 8A is a plan view, and FIG. 8B is a front view;
FIG. 9 is a schematic view showing a method of manufacturing the semiconductor assembly shown in FIG. 4;
FIG. 10 is a schematic view showing a method of manufacturing the semiconductor assembly shown in FIG. 4;
FIG. 11 is a schematic view showing a method of manufacturing the semiconductor assembly shown in FIG. 4;
FIG. 12 is a schematic view showing a process of forming an inclined face on a phosphor layer before dividing a semiconductor assembly into individual pieces;
FIG. 13 is a schematic view showing a process of manufacturing a light emitting apparatus by mounting a divided individual piece of the semiconductor assembly on a substrate; and
FIG. 14 is a plan view of a light emitting apparatus according to a second embodiment of the present invention.

### Description of Characters

- 1:: submount
- 1a:: silicon substrate
- 1b:: p-type semiconductor region
- 1c:: n electrode
- 1d:: n-side electrode
- 1e:: p-side electrode
- 1f:: wire connection region
- 2:: semiconductor light emitting device
- 2a:: substrate
- 2b:: active layer
- 2c:: n-side electrode
- 2d:: p-side electrode
- 2e and 2f:: bump electrode
- 3:: phosphor layer
- 4:: inclined face
- 10:: silicon wafer
- 11:: phosphor paste
- 12:: mask
- 13:: metal mask
- 14:: phosphor paste
- 15:: transfer plate
- 16:: phosphor paste
- 20:: lighting apparatus (light emitting apparatus)
- 21:: substrate
- 21a:: aluminum
- 21b:: alumina composite layer
- 21c:: via
- 22:: semiconductor assembly
- 23:: reflecting frame
- 24:: lens unit
- 25:: resin layer
- 26:: wiring pattern
- 26a:: wiring pattern
- 26b:: wiring pattern
- 26c:: via
- 27:: wire
- 28:: blade
- 29:: dicer

### BEST MODE OF CARRYING OUT THE INVENTION

A first aspect of the present invention is characterized in that, in a light emitting apparatus including a plurality of semiconductor light emitting devices each having a light emitting face, at least part of the light emitting face being covered with a phosphor layer and a substrate, each of one or more submounts is mounted on the substrate in assembled condition with at least one of the plurality of semiconductor light emitting devices. Accordingly, chromaticity characteristics of the semiconductor assembly can be measured before the semiconductor assembly is mounted on the substrate. Therefore, even if using a plurality of semiconductor light emitting devices, before mounting of the semiconductor assembly on the substrate, a semiconductor assembly can be prepared on which the semiconductor light emitting devices each having uniform chromaticity characteristics are mounted. And, a light emitting apparatus having suppressed dispersion of chromaticity can be manufactured.

A second aspect of the present invention is characterized in that the phosphor layer has at least one inclined face that connects a top face and one of lateral faces of the phosphor layer, and a minimum distance from the inclined face to the semiconductor light emitting device is substantially equal to a thickness of the phosphor layer, or the phosphor layer has at least one inclined lateral face, and a minimum distance from the inclined lateral face to the semiconductor light emitting device is substantially equal to a thickness of the phosphor layer. A ridge line portion of the top face of the phosphor layer is an inclined face. A distance of the ridge line portion is a longest distance that light emitted from the semiconductor light emitting device passes through the phosphor layer. Accordingly, light emitted from the semiconductor light emitting device can pass through a phosphor layer having a substantially uniform distance in every direction. Therefore, the wavelength conversion degree of due to a phosphor can be uniform in a top face and an inclined lateral face. Therefore, a semiconductor assembly having uniform chromaticity characteristics in every direction can be prepared.

Furthermore, since a phosphor layer having an inclined face can be easily formed by grounding, a semiconductor assembly including a phosphor layer having a mass-producible shape can be realized.
A third aspect of the present invention characterized in that having a method of manufacturing a light emitting apparatus comprising: a substrate, one or more submounts, and a plurality of semiconductor light emitting devices each having a light emitting face, at least part of which being covered with a phosphor layer, the method comprising the steps of: mounting at least one of the plurality of semiconductor light emitting devices on each of the one or more submounts; assembling a semiconductor assembly by forming the phosphor layer so as to cover each of the semiconductor light emitting devices; selecting a plurality of semiconductor assemblies each having a predetermined chromaticity characteristic by measuring each chromaticity characteristic of the semiconductor assemblies; and mounting the selected plurality of semiconductor assemblies on the substrate. The semiconductor assembly obtained by assembling the submount and the semiconductor light emitting device is mounted on the substrate. Accordingly, chromaticity characteristics of the semiconductor assembly can be measured before the semiconductor assembly is mounted on the substrate.
Therefore, even if using a plurality of semiconductor light emitting devices, a semiconductor assembly can be prepared on which the semiconductor light emitting devices each having uniform chromaticity characteristics are mounted before the semiconductor assembly is mounted on the substrate. And, a light emitting apparatus having suppressed dispersion of chromaticity can be manufactured.

### (First Embodiment)

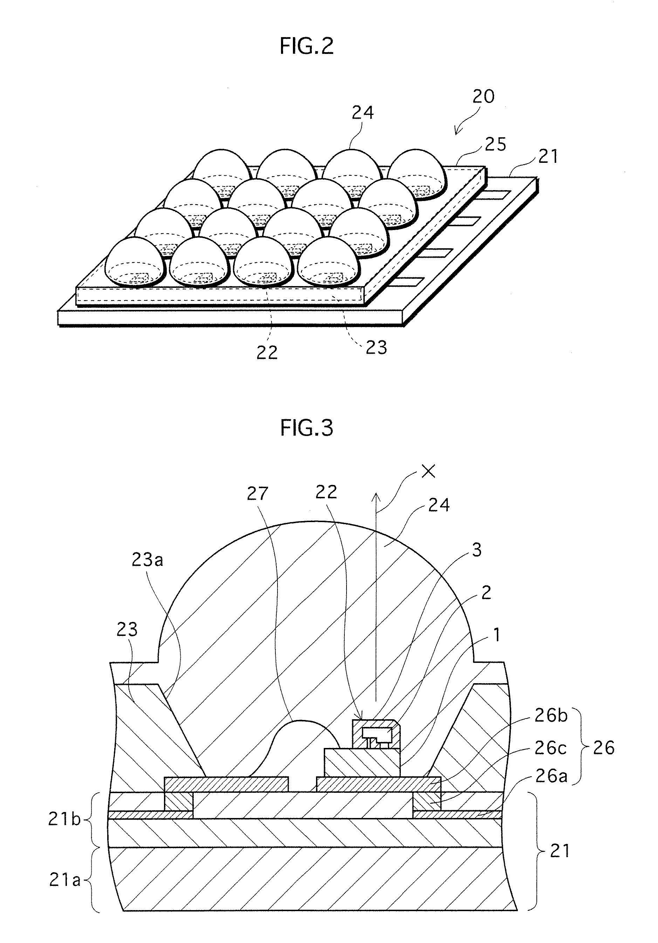

A structure of a lighting apparatus as a light emitting apparatus according to a first embodiment of the present invention is described with reference to FIG. 2 and FIG. 3. FIG. 2 is a perspective view of the light emitting apparatus according to the first embodiment of the present invention. FIG. 3 is a fragmentary enlarged sectional view of the light emitting apparatus.
As shown in FIG. 2 and FIG. 3, a lighting apparatus 20 includes a substrate 21, a plurality of semiconductor assemblies 22 mounted on the substrate 21, a reflecting frame 23 having an opening in a position where each of the semiconductor assemblies 22 is arranged on the substrate 21, and a resin layer 25 having a lens unit 24 formed thereon, the lens unit 24 covering the reflecting frame 23 and being convex in a light emitting direction of the semiconductor assembly 22.

Note that, in the description of the lighting apparatus according to the first embodiment, the light emitting direction of the semiconductor assembly 22 shown by an arrow-head X in FIG. 3 is assumed as an upward direction. That is, the upward direction is a direction perpendicular to a face of the substrate 21 on which the semiconductor assembly is mounted, and a direction that directs from the substrate 21 to the lens unit 24. Also, a direction opposite to the direction shown by the arrow-head X is assumed as a downward direction, and a direction perpendicular to the direction shown by the arrow-head X is assumed as a lateral direction.
The substrate 21 is composed of an aluminum 21a and an alumina composite layer 21b. The aluminum 21a has a thickness of 1 mm. The alumina composite layer 21b is composed so as to cover the aluminum 21a. The alumina composite layer 21b is composed of alumina and resin, and has a bilayer structure in the present embodiment. A wiring pattern 26a is formed on a first layer of the alumina composite layer 21b, and a second layer of the alumina composite layer 21b is further formed thereon. A wiring pattern 26b is formed on a surface of the second layer of the alumina composite layer 21b. The wiring pattern 26a and the wiring pattern 26b are electrically connected with each other through a via 26c formed on the second layer of the alumina composite layer 21b. Hereinafter, "wiring pattern 26" indicates the wiring patterns 26a and 26b, and the whole via 26c. Each of the first and second layer of the alumina composite layer 21b has a thickness of 0.1 mm. Note that the substrate 21 may be composed of ceramic having a monolayer or multilayer structure. The substrate 21 is connected with the semiconductor assembly 22 by Ag paste.

The semiconductor assembly 22 is conductively connected with the wiring pattern 26 formed on the substrate 21 via a wire 27. The wire 27 is composed of gold.
The reflecting frame 23 is metal, and reflects horizontal light (light to the lateral side) emitted from the semiconductor assembly 22 by a reflecting face 23a thereof so as to emit the light perpendicularly (to the upper side). The reflecting frame 23 is composed of aluminum or ceramic, for example.

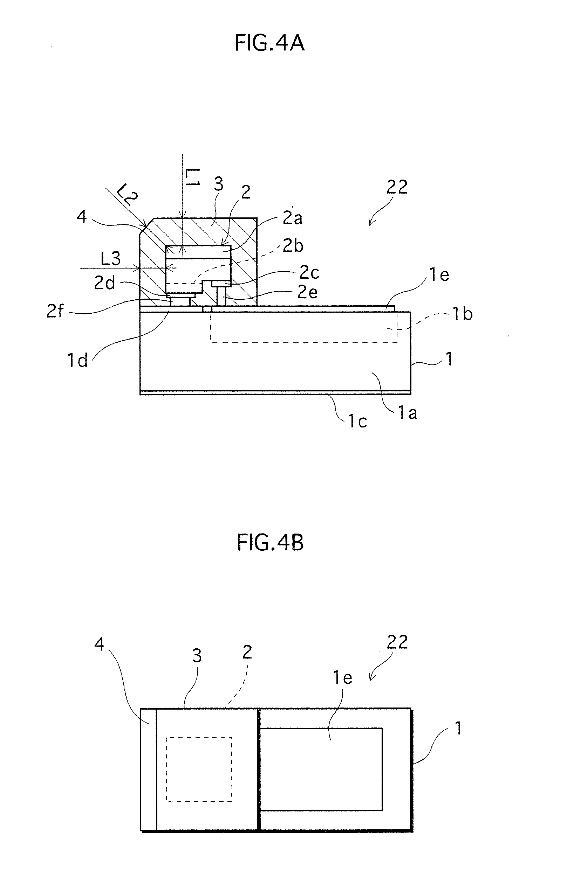

The following describes a structure of the semiconductor assembly 22 mounted on the lighting apparatus 20 in detail with reference to FIG. 4. FIG. 4 shows a structure of the semiconductor assembly used for the light emitting apparatus according to the first embodiment of the present invention, where FIG. 4A is a partially broken side view, and FIG. 4B is a plan view.
As shown in FIG. 4, the semiconductor assembly 22 used for the lighting apparatus according to the first embodiment of the present invention includes a submount 1, a semiconductor light emitting device 2 mounted thereon, and a phosphor layers 3 including a phosphor that covers whole of the semiconductor light emitting device 2. The semiconductor assembly 22 is mounted on the substrate 21, and thereby the semiconductor light emitting device 2 is mounted on the substrate 21 so as to sandwich the submount 1.

The submount 1 is made using an n-type silicon substrate 1a. As shown in FIG. 4A, the silicon substrate 1a has a p-type semiconductor region 1b that partly faces a mounting face of the semiconductor light emitting device 2 (the upper side) . An n electrode 1c is formed on a bottom face of the silicon substrate 1a. An n-side electrode 1d joined with an n-type semiconductor layer of the silicon substrate 1a is mounted on the mounting face of the semiconductor light emitting device 2. A p-side electrode 1e is formed on a portion included in the p-type semiconductor region 1b.

The semiconductor light emitting device 2 is a blue light emitting LED having high luminance using a GaN compound semiconductor. The semiconductor light emitting device 2 is obtained by laminating, for example, a GaN n-type layer, an InGaN active layer, and a GaN p-type layer on a surface of a substrate 2a composed of sapphire. Subsequently, as conventionally known, a part of the p-type layer is etched to expose the n-type layer. An n-side electrode 2c is formed on a surface of the exposed n-type layer, and a p-side electrode 2d is formed on a surface of the p-type layer. The n-side electrode 2c is joined with the p-side electrode 1e via the bump electrode 2e. Also, the p-side electrode 2d is joined with the n-side electrode 1d via the bump electrode 2f.

Note that, in a complex device of the submount 1 and the semiconductor light emitting device 2, the n electrode 1c of the submount 1 may be conductively mounted on a wiring pattern of a printing substrate, for example. Also, the complex device may be an assembly that bonds a wire between the p electrode 1e in a region separated from the phosphor layer 3 and the wiring pattern. Moreover, the submount 1 may be a device having not only functions for energization to the semiconductor light emitting device 2 and mounting of the semiconductor light emitting device 2, but also a function for electrostatic protection using zener diode, for example. Furthermore, a plurality of semiconductor light emitting devices 2 may be mounted on the submount 1.

The phosphor layer 3 is composed of an epoxy resin conventionally used in the field of LED lamps, and is a mixture of the epoxy resin and a phosphor. In conversion into white light emission, as the phosphor to be mixed with the epoxy resin, a phosphor may be employed that has a complementary color to blue that is a light emitting color of the semiconductor light emitting device 2. A fluorescent dye, a fluorescent pigment, a phosphor, etc. may be used. For example, (Y,Gd)₃(Al,Ga)₅O₁₂:Ce is preferable.

Here, the semiconductor light emitting device 2 is a square planar as shown in FIG. 4B. The semiconductor light emitting device 2 emits light from an active layer 2b between the p-type layer and the n-type layer shown by a broken line in FIG. 4A. And, the light emitted from the active layer 2b transmits through the transparent sapphire substrate 2a. Therefore, a top face of the substrate 2a shown in FIG. 4A is a main light extracting face.
The light emitted from the active layer 2b directs not only in a direction of the substrate 2a, but also in the lateral direction and in a direction of a surface of the submout device 1 (in the downward direction). The light that directs to the lateral side is emitted outside from the phsophor layer 3. Also, the light that directs to the surface of the submout device 1 is reflected by the metal-glossy n-side electrode 1d and p-side electrode 1e. Therefore, the light extracted from the main light extracting face has a maximum light emission intensity among the lights emitted from the semiconductor light emitting device 2. However, the semiconductor light emitting device 2 is a minute square planar having approximately 350 µm on a side. Therefore, light is uniformly emitted from whole the semiconductor light emitting device 2. In the mode of light emission from the semiconductor light emitting device 2, there is conventionally dispersions of a thickness and a filling amount of a sealing resin having a phosphor mixed therewith. Therefore, the semiconductor light emitting device 2 emits yellowish light although the semiconductor light emitting device 2 would emit white light in a normal situation. That is, since an intensity of wavelength conversion effect of the phosphor changes depending on a distance that light passes through the phosphor, the light that passes through a thick angle portion of the sealing resin emits intense green-yellow light, thereby this light glows yellowish.

Compared with the above light emission, in the present invention as clear from FIG. 4A and FIG. 4B, an inclined face 4 is formed that connects the top face and lateral face of the phosphor layer 3 on one of sides of the top face of the phosphor layer 3. As a result, the following three distances can be substantially equal to each other: a distance L1 from the light emitting face of the semiconductor light emitting device 2 to the top face of the phosphor layer 3 (a thickness of the phosphor layer 3); a distance L2 from the light emitting face to the inclined face 4 (a minimum distance from the inclined face 4 to the semiconductor light emitting device 2); and a distance L3 from the light emitting face to the lateral face. That is, while the light emitted from the active layer 2b passes through the phosphor layer 3, uniform wavelength conversion due to the phosphor can be achieved.
Suppose that an inclined face is not formed on the phosphor layer 3. Here, light that passes a longest distance through the phosphor layer 3 among the lights emitted from the semiconductor light emitting device 2 is light emitted in a direction of each side of the top face of the phosphor layer 3 (hereinafter, direction that passes through each side of the virtual top face). Therefore, as shown in FIG. 4A and FIG. 4B, by forming the inclined face 4 that connects the top face and the lateral face of the phosphor layer 3 on the top face of the phosphor layer 3, the distance that the light emitted from the semiconductor light emitting device 2 to each side of the virtual top face passes through the phosphor layer 3 can be substantially equal to the distance that the light emitted to the top face and the lateral face of the phosphor layer 3 passes through the phosphor layer 3.

In this way, by forming the inclined face 4 that connects the top face and the lateral face of the phosphor layer 3 that covers the semiconductor light emitting device 2, in a side where the inclined face 4 is formed due to wavelength conversion by light emitted from the semiconductor light emitting device 2, each distance that light passes through the phosphor layer is substantially uniform. Accordingly, in the side where the inclined face 4 is formed, the light emitted from the phosphor layer 3 can be obtained as white light.

In FIG. 4B, the inclined face 4 is formed on one of the sides of the top face of the phosphor layer 3. However, the inclined face 4 is desirably formed on each of all the four sides. This enables each distance the light emitted from the semiconductor light emitting device 2 passes through the phosphor layer 3 toward all the four directions substantially equal to each other. The following describes a first and second modification examples according to the phosphor layer 3 having an inclined faces 4 formed on all the four sides thereof.

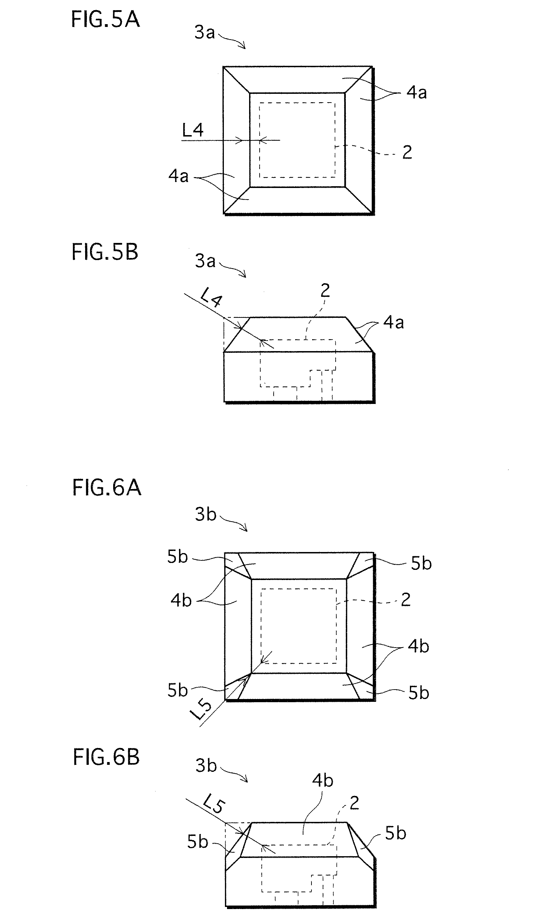

FIG. 5 shows a phosphor layer according to the first modification example, where FIG. 5A is a plan view, and FIG. 5B is a front view. On a phosphor layer 3a according to the first modification example, an inclined face 4a that connects a top face and a lateral face of the phosphor layer 3a is formed on each of all four sides on the top face. A minimum distance from each of the inclined faces 4a to a semiconductor light emitting device 2 is substantially equal to a distance from a light emitting face of the semiconductor light emitting device 2 to a top face of the phosphor layer 3a (a thickness of the phosphor layer 3a).
Therefore, a distance that L4 the light emitted from the semiconductor light emitting device 2 toward a direction that passes through each side of the virtual top face passes through the phosphor layer 3a can be substantially equal to a distance that light that directs to the top face and the lateral face of the phosphor layer 3a passes through the phosphor layer 3a.

FIG. 6 shows a phosphor layer according to the second modification example, where FIG. 6A is a plan view, and FIG. 6B is a front view. On a phosphor layer 3b according to the second modification example, an inclined face 4b that connects a top face and a lateral face of the phosphor layer 3b is formed on each of all four sides on the top face. Furthermore, on each of all boundaries between the adjacent inclined faces 4b, an inclined face 5b is formed that connects the adjacent inclined faces 4b. A minimum distance from each of the inclined faces 4b and each of the inclined faces 5b to the semiconductor light emitting device 2 is substantially equal to a distance from a light emitting face of the semiconductor light emitting device 2 to a top face of the phosphor layer 3b (a thickness of the phosphor layer 3b).
Therefore, a distance that light emitted from the semiconductor light emitting device 2 toward the direction that passes through each side of the virtual top face passes thorough the phosphor layer 3b can be substantially equal to a distance that the light that directs the top face and the lateral face of the phosphor layer 3b passes through the phosphor layer 3b. In this case, the inclined faces 5b are formed, thereby a direction that light passes a longest distance through the phosphor layer 3b among the sides of the virtual top face passes thorough, namely a distance L5 the light emitted toward a direction that passes each angle of the virtual top surface can be substantially equal to a distance that light that directs the top surface or the lateral surface of the phosphor layer 3b passes thorough the phosphor layer 3b.

Also, the phosphor layer 3 according to the first embodiment may have at least one inclined lateral face. The following describes a third and a fourth modification examples according to the phosphor layer 3 having an inclined lateral face.

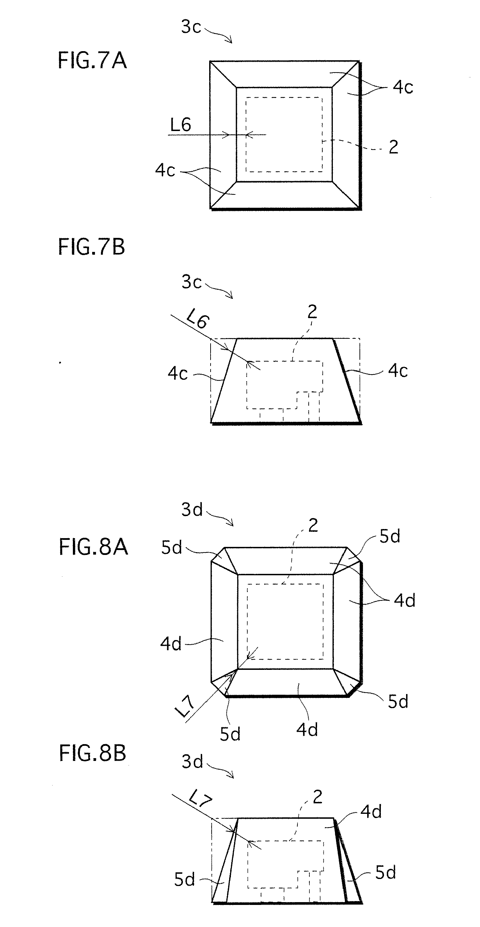

FIG. 7 shows a phosphor layer according to the third modification example, where FIG. 7A is a plan view, and FIG. 7B is a front view. In a phosphor layer 3c according to the third modification example, each of all four lateral faces is an inclined faces 4c. A minimum distance from the inclined face 4c to a semiconductor light emitting device 2 is substantially equal to a distance from a light emitting face of the semiconductor light emitting device 2 to a top face of the phosphor layer 3c (a thickness of the phosphor layer 3c).
Therefore, a distance L6 the light emitted from the semiconductor light emitting device 2 toward a direction that passes through each side of the virtual top face passes through the phosphor layer 3c can be substantially equal to a distance the light that directs the top face and the lateral face of the phosphor layer 3c passes through the phosphor layer 3c.

FIG. 8 shows a phosphor layer according to the fourth modification example, where FIG. 8A is a plan view, and FIG. 8B is a front view. In a phosphor layer 3d according to the fourth modification example, each of all four lateral faces is an inclined face 4d. Furthermore, on all boundaries between the adjacent inclined face 4d, an inclined face 5d is formed that connects the adjacent inclined faces 4d. A minimum distance from the inclined face 4d and the inclined face 5d to a semiconductor light emitting device 2 is substantially equal to a distance from a light emitting face of the semiconductor light emitting device 2 to a top face of the phosphor layer 3d (a thickness of the phosphor layer 3d).
Therefore, a distance L7 that light emitted from the semiconductor light emitting device 2 toward a direction that passes through each side of the virtual top face passes through the phosphor layer 3d can be substantially equal to a distance that light that directs the top face and the lateral face of the phosphor layer 3d passes through the phosphor layer 3d. In this case, the inclined faces 5d are formed, thereby a direction that light passes a longest distance through the phosphor layer 3d among the sides of the virtual top face passes thorough, namely the distance L7 the light emitted toward a direction that passes each angle of the virtual top surface can be substantially equal to a distance that light that directs the top surface or the lateral surface of the phosphor layer 3d passes thorough the phosphor layer 3d.

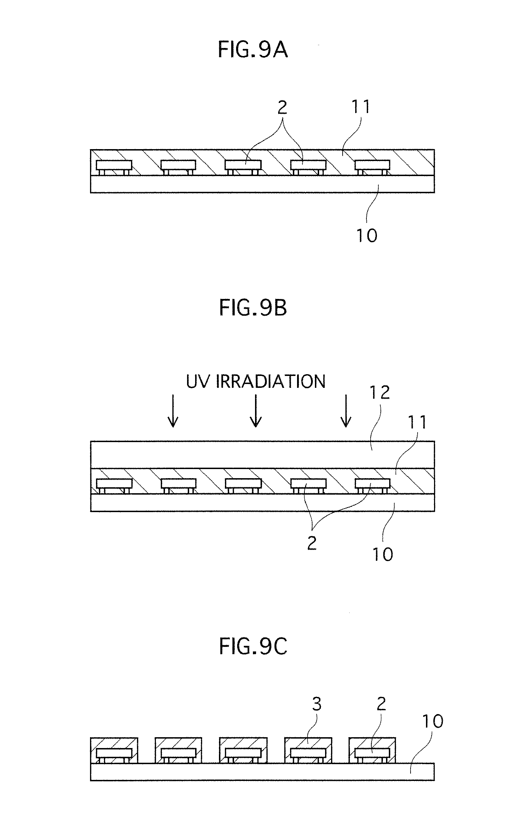

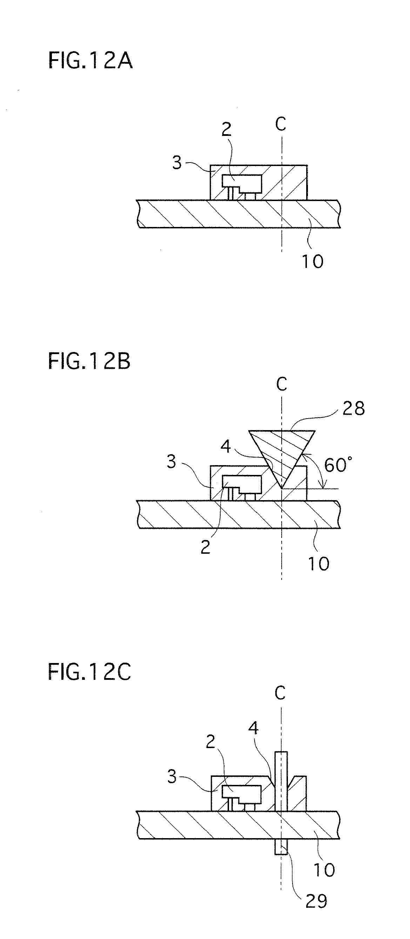

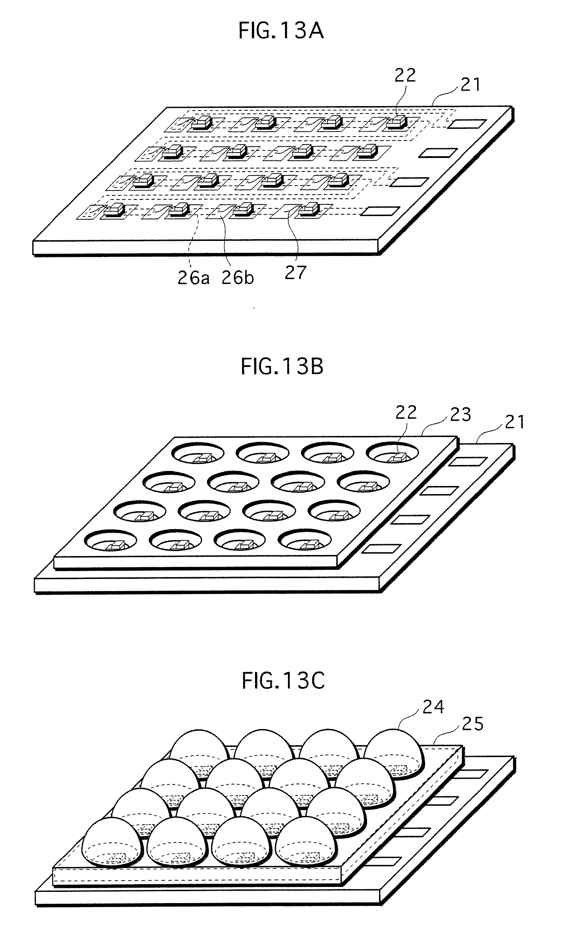

The following describes a method of manufacturing the lighting apparatus as the light emitting apparatus according to the first embodiment of the present invention with reference to the drawings. FIG. 9 to FIG. 11 are schematic views each showing a method of manufacturing the semiconductor assembly shown in FIG. 4. FIG. 12 is a schematic view showing a process of forming an inclined face on a phosphor layer before dividing a semiconductor assembly into individual pieces. FIG. 13 is a schematic view showing a process of manufacturing a light emitting apparatus by mounting one of the divided individual pieces of the semiconductor assembly on a substrate.

First, in each manufacturing method, a process is described where a phosphor layer 3 is formed by mounting a semiconductor light emitting device 2 on a silicon wafer having a plurality of submount 1 formed thereon. And, a process is described where a semiconductor assembly is divided into pieces by dicing. Subsequently, a process is described where a lighting apparatus is manufactured by mounting one of the divided pieces of the semiconductor assembly on the substrate.
FIG. 9 shows a method of manufacturing a semiconductor assembly using a photolithography method.
The p-type semiconductor region 1b shown in FIG. 4 is formed on the silicon wafer 10. First, the silicon wafer 10 is prepared, which is obtained by pattern-forming the n electrode 1c, the n-side electrode 1d, and the p-side electrode 1e. Then, a semiconductor light emitting device 2 is mounted in accordance with a pattern of the n-side electrode 1d and the p-side electrode 1e. In the semiconductor light emitting device 2, the bump electrode 2e is formed on the n-side electrode 2c, and the bump electrode 2f is formed on the p-side electrode 2d. As shown in FIG. 9A, a phosphor paste 11 having a uniform thickness is coated on the surface of the silicon wafer 10. The phosphor paste 11 is a mixture of an ultraviolet-curable resin such as an acrylic resin and a phosphor such as the above-mentioned (Y, Gd)₃ (Al, Ga)₅O₁₂:Ce, for example. Note that the p-type semiconductor region 1b, the electrodes 1c, 1d, 1e, 2c, 2d, 2e, and 2f are not shown in FIG. 9. After coating the phosphor paste 11, a mask for pattern formation is covered on the silicon wafer 10, and ultraviolet light is irradiated thereon, as shown in FIG. 9B, to harden a portion of the phosphor paste 11 in a position that covers the semiconductor light emitting device 2. And then, in a subsequent development process, an unnecessary portion of the phosphor paste 11 is removed, thereby the phosphor layer 3 is formed (FIG. 9C).

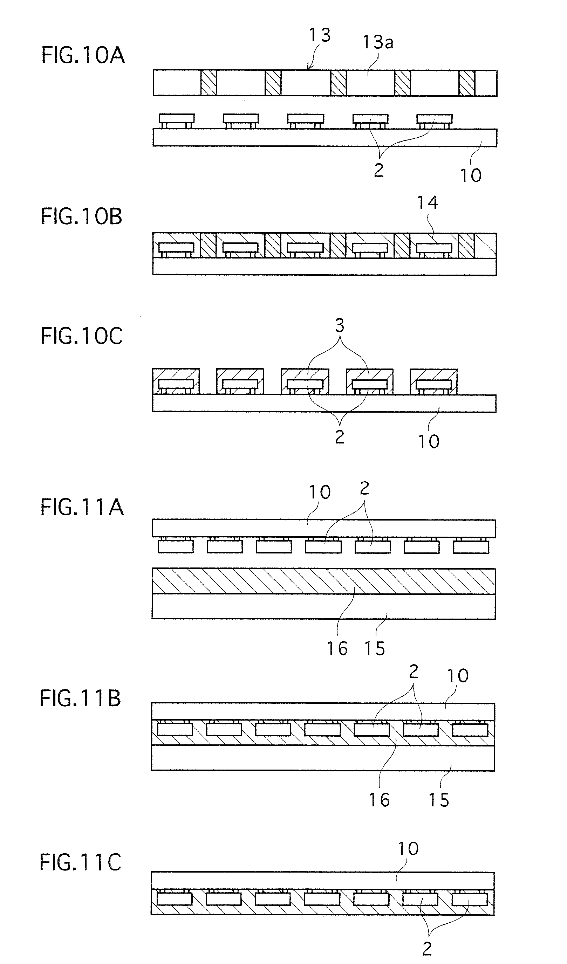

FIG. 10 shows a method of manufacturing a semiconductor assembly using a screen printing method. The process of mounting the semiconductor light emitting device 2 on the silicon wafer 10 is the same as that of the example shown in FIG. 9. After mounting the semiconductor light emitting device 2, a pre-manufactured metal mask 13 is placed on the silicon wafer 10 (FIG. 10A and FIG. 10B) . And then, the phosphor paste 14 is coated on the surface of the semiconductor light emitting device 2 using the screen printing method. The phosphor paste 14 is not ultraviolet-curable, and is a mixture of a resin such as an epoxy resin, a phosphor, and a thixotropic material. After coating the phosphor paste 14, the metal mask 13 is removed. And the semiconductor light emitting device 2 is thermally hardened, thereby the phosphor layer 3 that covers the light emitting device 3 is formed on the surface of the silicon wafer 10 (FIG. 10C).

FIG. 11 shows a method of manufacturing a semiconductor assembly using a transfer method. A transfer plate 15 is prepared whose surface is coated beforehand with a phosphor paste 16. The silicon wafer 10 having the semiconductor light emitting device 2 mounted thereon is maintained upside down (FIG. 11A). Subsequently, the silicon wafer 10 is covered on the transfer plate 15 so as to immerse the semiconductor light emitting device 2 in the phosphor paste 16 (FIG. 11B). And then, the silicon wafer 10 is withdrawn, and thereby the semiconductor light emitting device 2 covered by the phosphor paste 16 can be obtained, as shown in FIG. 11C. The phosphor paste 16 is a mixture of a resin and a phosphor, which is the same as the phosphor paste 16. In manufacturing the semiconductor assembly using the transfer method, a resin used for the phosphor paste 16 is not limited to an acrylic resin and an epoxy resin, and may be other resin.

As described above, by using the photolithography method, the screen printing method, or the transfer method, the semiconductor assembly before being divided into individual pieces can be obtained.
The following describes the process of dividing the semiconductor assembly into individual pieces by dicing, with reference to FIG. 12. FIG. 12 is a schematic view showing the process of dividing the semiconductor assembly into individual pieces by dicing.

FIG. 12A is an enlarged view of one of the divided pieces of the semiconductor assembly before being diced using the manufacturing methods shown in FIG. 9 to FIG. 11. A cut part C shown by a dotted line in FIG. 12A is a boundary between the semiconductor assembly and an adjoining semiconductor assembly.
First, as shown in FIG. 12B, a cut is made to a position shown by the cut part C that is the boundary with the adjoining semiconductor assembly using a blade 28 so as not to abut against the silicon wafer 10. A grounding face of the blade 28 is inclined to the vertical direction (the top face of the silicon wafer 10 intersects the grounding face at 60 degrees). Therefore, only making a cut to the phosphor layer 3 using the blade 28 can easily form an inclined lateral face 4 of the phosphor layer 3.

Next, a position shown by the cut part C of the silicon wafer 10 is cut using the dicer 29, shown in FIG. 12C. In this way, individual pieces of semiconductor assemblies 22 are manufactured.
In FIG. 4, only one inclined face 4 is formed. Also, while changing an orientation of the blade 28 or an orientation of the silicon wafer 10, the silicon wafer 10 is cut using the blade 28, and is grounded. This can enable easy forming of an inclined face in another position. For example, like in the case of the phosphor layer 3a shown in FIG. 5 and the phosphor layer 3c shown in FIG. 7, the inclined faces 4a and 4c can be formed in four positions. Furthermore, like in the case of the phosphor layer 3b shown in FIG. 6 and the phosphor layer 3d shown in FIG. 8, the inclined faces 5a and 5b can be formed in four positions that are boundaries with the inclined faces 4b and 4d.

Also, the square-pole-shaped phosphor layer 3 is used in the first embodiment. However, if another multiple-pole-shaped phosphor layer is used, only making a cut to the multiple-pole-shaped phosphor layer from above using the blade 28 can form an inclined face that connects a top face and a lateral face thereof.
Also, by making a deep cut to the phosphor layer using the blade 28, or inclining a side wall of an opening 13a of the metal mask 13 shown in FIG. 10, an inclined lateral face of the phosphor layer 3 can be formed.

Note that, in the above description, the blue light emitting device is converted into the white light emitting device as one example. However, a structure may be employed where each light emission of ultraviolet ray, a red light emitting device, and a green light emitting device is converted into various kinds of light emitting colors using characteristics of a phosphor.
The following describes the process of manufacturing a light emitting apparatus by mounting one of the individual pieces of the semiconductor assemblies on a substrate with reference to FIG. 13.

First, a chromaticity point (x, y) in a CIE chromaticity diagram as the chromaticity characteristics of the semiconductor assembly 22 on which the process shown in FIG. 12 is performed is measured using a chromaticity measuring device.
As a result of the chromaticity measurement of the semiconductor assembly 22, in the case of a lighting apparatus that emits white color light, values of x and y are selected from a range within x = (0.34 to 0.37) and y = (0.34 to 0.37). Also, in the case of a lighting apparatus that emits incandescent lamp color light, values of x and y are selected from a range within x = (0.40 to 0.47) and y = (0.39 to 0.41). In this way, by selecting a predetermined value of the chromaticity characteristics of the semiconductor assembly 22, a lighting apparatus having a desired color can be easily manufactured.

Next, the semiconductor assembly 22 having a chromaticity characteristics whose value is within a predetermined range is mounted on the substrate having the wiring pattern 26 formed thereon. The mounted semiconductor assembly 22 is conductively connected with the wiring pattern 26 via the wire 27 (FIG. 13A).
And, the reflecting frame 23 is attached to the substrate 21 having the semiconductor assembly 22 mounted thereon such that the semiconductor assembly 22 corresponds in position with the opening of the reflecting frame 23. Although not shown in the figure, the reflecting frame 23 is attached by inserting a screw into a through-hole formed on the reflecting frame 23, and screwing the screw into the substrate 21 (FIG. 13B).

And finally, the substrate 21 is closed up using a convex mold so as to make a form of the lens unit 24. An optically-transparent resin is poured into the inside of the mold, and thereby the resin layer 25 having the lens unit 24 formed thereon is formed (FIG. 13C). Note that the resin layer is made of epoxy resin.
As described above, the lighting apparatus according to the first embodiment of the present invention can be manufactured.
In the conventional lighting apparatus shown in FIG. 1, dispersion of chromaticity characteristics is observed in each semiconductor light emitting device that coats the phosphor layer, as follows: x = (0.30 to 0.42), and y = (0.30 to 0.42). However, in the lighting apparatus according to the first embodiment of the present invention, chromaticity characteristics of the semiconductor assembly are measured before mounting the semiconductor assembly on the substrate, as described above. This allows selection of a semiconductor assembly having a predetermined chromaticity characteristics. In the case of a lighting apparatus that emits white color light, a semiconductor assembly can be selected whose chromaticity characterisitcs are as follows: x = (0.34 to 0.37), and y = (0.34 to 0.37). Also, in the case of a lighting apparatus that emits incandescent lamp color light, a semiconductor assembly can be selected whose chromaticity characterisitcs are as follows: x = (0.40 to 0.47), and y = (0.39 to 0.41). This can suppress dispersion of chromaticity characterisitcs of a semiconductor assembly mounted on a lighting apparatus, and also can achieve a desired tone in the lighting apparatus.

### (Second Embodiment)

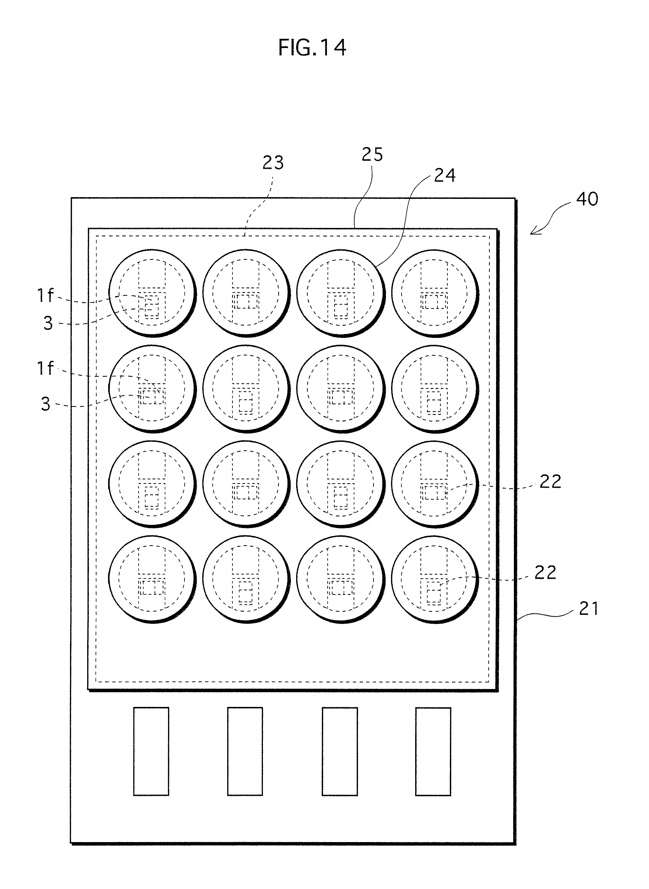

The following describes a structure of a lighting apparatus as a light emitting apparatus according to a second embodiment of the present invention with reference to FIG. 14. FIG. 14 is a plan view of the light emitting apparatus according to the second embodiment of the present invention.
A lighting apparatus according to the second embodiment of the present invention is characterized having the structure where the semiconductor assemblies of the lighting apparatus shown in FIG. 2 are mounted in a matrix arrangement, and a positional relation between the semiconductor light emitting device and a wire connection region of the submount in each semiconductor assembly is different from that in any adjoining semiconductor assembly in the matrix arrangement.

Note that, in FIG. 14, compositional elements having the same structure as that in FIG. 2 has the same signs, and thereby the description is omitted here.
As shown in FIG. 14, a lighting apparatus 40 includes a substrate 21, a plurality of semiconductor assemblies 22 mounted on the substrate 21, a reflecting frame 23 having an opening in a position where the semiconductor assembly 22 is arranged on the substrate 21, and a resin layer 25 having a lens unit 24 formed thereon, the lens unit 24 covering the reflecting frame 23 and being convex in a light emitting direction of the semiconductor assembly 22.

As shown in FIG. 4, the semiconductor assembly 22 is formed by flip-chip mounting a semiconductor light emitting device 2 on a p-side electrode 1e and an n-side electrode 1d formed on a submount 1. In the semiconductor assembly 22, an n electrode 1c of the submount 1 is used as a cathode, and the p-side electrode 1e is used as an anode. As shown in FIG. 3, the cathode conducts by mounting the semiconductor assembly 22 on a wiring pattern 26, and the anode conducts with the wiring pattern 26 via a wire 27.

Namely, in order to secure a region for connecting a region where the semiconductor light emitting device 2 is mounted on the submount 1 and a wire on the p-side electrode 1e (wire connection region), the p-side electrode 1e having a larger space. Therefore, the semiconductor light emitting device 2 is formed on a position out of the center on a surface of the submount 1.
As described in the first embodiment, a layer is formed that covers the semiconductor light emitting device 2 using the photo lithography method, the screen printing method, the transfer method, etc, the layer being as an origin of the phosphor layer 3. As shown in FIG. 12, a cut is made to a position shown by a cut part C that is a boundary with an adj acent semiconductor assembly using the blade 28 so as not to abut against the silicon wafer 10. And then, the silicon wafer 10 and sides of the phosphor layer 3 are cut using the dicer 29, and thereby the submount is formed as one of the individual pieces of the semiconductor assembly.

When the silicon wafer 10 and the phosphor layer 3 are cut using the dicer 29, a thickness from the light emitting face of the semiconductor light emitting device 2 to the surface of the phosphor layer 3 in a side facing the cut part using the dicer 29 is greater than that in a side facing the wire connection region, namely, an opposite side of the side facing the curt part. This is because a distance between the semiconductor assembly and the semiconductor light emitting device 2 is secured.
Namely, the thicker phosphor layer 3 has a higher wavelength conversion degree due to a phosphor. For example, in the case where a semiconductor light emitting device that emits blue light is covered with a phosphor layer 3 including a phosphor that has a complementary color to blue, a thicker face of the phosphor layer 3 emits yellowish light although the face would emit white light in a normal situation. This indicates that there is a difference of chromaticity characteristics between a thicker portion and a thinner portion in the phosphor layer 3.

If the semiconductor assembly whose thickness is different in the semiconductor light emitting device 2 and the surface of the phosphor layer 3 is mounted such that a positional relation between the semiconductor light emitting device 2 and the wire connection region in each semiconductor assembly is equal to a positional relation between the semiconductor light emitting device and a wire connection region of the submount in any adjoining semiconductor assembly in a matrix arrangement as shown in FIG. 13, lines caused by difference between chromaticity characteristics of light emitted from the semiconductor assemblies are made to give a streaked appearance.

Therefore, the semiconductor assembly of the lighting apparatus 40 according to the second embodiment as shown in FIG. 14, is mounted in a matrix arrangement, and a positional relation between the semiconductor light emitting device 2 and a wire connection region 1f of the submount 1 having the semiconductor light emitting device 2 mounted thereon in each semiconductor assembly (a region occupied by the p-side electrode 1e) is different from that in any adjoining semiconductor assembly in the matrix arrangement.
In this way, the semiconductor assemblies are arranged such that in adjoining semiconductor assembly in the matrix arrangement, the positional relation between the semiconductor light emitting device 2 and the wire connection region 1f alternately changes 90 degree turn. This can suppress the dispersion of chromaticity of streaked appearance.

In the present embodiment, the semiconductor assemblies are arranged such that the positional relation alternately changes 90 degree turn. However, the present invention is not limited to this arrangement. The positional relation may alternately change 45 or 180 degree turn. In this way, the positional relation in a semiconductor assembly is different from that of any semiconductor assembly in a matrix arrangement. This can suppress the dispersion of chromaticity of streaked appearance. In order to further suppress the chromaticity dispersion, the phosphor layer 3 according to the second embodiment has a shape as the same as that of the phosphor layers 3a, 3b, 3c, or 3 shown in FIG. 5 to FIG. 8.

### INDUSTRIAL APPLICABILITY

The present invention can suppress dispersion of chromaticity, and therefore is preferable for a light emitting apparatus including: a plurality of semiconductor light emitting devices each having a light emitting face, at least part of the light emitting face being covered with a phosphor layer and a substrate. Moreover, the light emitting apparatus according to the present invention can be widely applicable to indoor lighting apparatuses, outdoor lighting apparatuses, table lightings, portable lightings, strobe lightings for cameras, light sources for display, back lights of liquid crystal displays, lightings for image scanning, etc.

## Claims

1. A light emitting apparatus comprising:
a plurality of semiconductor light emitting devices each having a light emitting face, at least part of the light emitting face is covered with a phosphor layer;
one or more submounts; and
a substrate, wherein
each of the plurality of semiconductor light emitting devices is mounted on any one of the one or more submounts, and the one or more submounts are mounted on the substrate.

2. The light emitting apparatus of Claim 1, wherein
each of the one or more submounts is mounted on the substrate in assembled condition with at least one of the plurality of semiconductor light emitting devices.

3. The light emitting apparatus of Claim 1 or 2, wherein
the phosphor layer has at least one inclined face that connects a top face and one of lateral faces of the phosphor layer, and a minimum distance from the inclined face to the semiconductor light emitting device is substantially equal to a thickness of the phosphor layer.

4. The light emitting apparatus of Claim 1 or 2, wherein
the phosphor layer has at least one inclined lateral face, and a minimum distance from the inclined lateral face to the semiconductor light emitting device is substantially equal to a thickness of the phosphor layer.

5. The light emitting apparatus of any of Claims 1 to 4, wherein
the semiconductor assembly is mounted in a matrix arrangement, and a positional relation between the semiconductor light emitting device and a wire connection region of the submount in each semiconductor assembly is different from a positional relation between the semiconductor light emitting device and a wire connection region of the submount in any adjoining semiconductor assembly in the matrix arrangement.

6. A method of manufacturing a light emitting apparatus comprising: a plurality of semiconductor light emitting devices each having a light emitting face, at least part of the light emitting face being covered with a phosphor layer; one or more submounts; and a substrate, the method comprising the steps of:
mounting each of the plurality of semiconductor light emitting devices on any one of the one or more submounts;
forming one or more semiconductor assemblies by forming the phosphor layer so as to cover each of the semiconductor light emitting devices;
measuring a chromaticity characteristic of each semiconductor assembly to select one or more semiconductor assemblies each having a predetermined chromaticity characteristic from among the semiconductor assemblies; and
mounting the selected one or more semiconductor assemblies on the substrate.

7. The method of manufacturing the light emitting apparatus of Claim 6, wherein
in the step of mounting the selected one or more semiconductor assemblies on the substrate, the selected semiconductor assemblies are mounted on the substrate in a matrix arrangement such that a positional relation between the semiconductor light emitting device and a wire connection region of the submount in each semiconductor assembly is different from a positional relation between the semiconductor light emitting device and a wire connection region of the submount in any adjoining semiconductor assembly in the matrix arrangement.

## Amended claims

### Amended claims under Art. 19.1 PCT

**1.** A light emitting apparatus comprising:
a plurality of semiconductor light emitting devices each having a light emitting face, at least part of the light emitting face is covered with a phosphor layer;
one or more submounts; and
a substrate, wherein
each of the plurality of semiconductor light emitting devices is mounted on any one of the one or more submounts, and the one or more submounts are mounted on the substrate.

**2.** The light emitting apparatus of Claim 1, wherein
each of the one or more submounts is mounted on the substrate in assembled condition with at least one of the plurality of semiconductor light emitting devices.

**3.** The light emitting apparatus of Claim 1 or 2, wherein
the phosphor layer has at least one inclined face that connects a top face and one of lateral faces of the phosphor layer, and a minimum distance from the inclined face to the semiconductor light emitting device is substantially equal to a thickness of the phosphor layer.

**4.** The light emitting apparatus of Claim 1 or 2, wherein
the phosphor layer has at least one inclined lateral face, and a minimum distance from the inclined lateral face to the semiconductor light emitting device is substantially equal to a thickness of the phosphor layer.

**5.** (Amended) The light emitting apparatus of Claim 1 or 2, wherein
the semiconductor assembly is mounted in a matrix arrangement, and a positional relation between the semiconductor light emitting device and a wire connection region of the submount in each semiconductor assembly is different from a positional relation between the semiconductor light emitting device and a wire connection region of the submount in any adjoining semiconductor assembly in the matrix arrangement.

**6.** (Added) The light emitting apparatus of Claim 3, wherein
the semiconductor assembly is mounted in a matrix arrangement, and a positional relation between the semiconductor light emitting device and a wire connection region of the submount in each semiconductor assembly is different from a positional relation between the semiconductor light emitting device and a wire connection region of the submount in any adjoining semiconductor assembly in the matrix arrangement.

**7.** (Added) The light emitting apparatus of Claim 4, wherein
the semiconductor assembly is mounted in a matrix arrangement, and a positional relation between the semiconductor light emitting device and a wire connection region of the submount in each semiconductor assembly is different from a positional relation between the semiconductor light emitting device and a wire connection region of the submount in any adjoining semiconductor assembly in the matrix arrangement.

**8.** (Amended) A method of manufacturing a light emitting apparatus comprising: a plurality of semiconductor light emitting devices each having a light emitting face, at least part of the light emitting face being covered with a phosphor layer; one or more submounts; and a substrate, the method comprising the steps of:
mounting each of the plurality of semiconductor light emitting devices on any one of the one or more submounts;
forming one or more semiconductor assemblies by forming the phosphor layer so as to cover each of the semiconductor light emitting devices;
measuring a chromaticity characteristic of each semiconductor assembly to select one or more semiconductor assemblies each having a predetermined chromaticity characteristic from among the semiconductor assemblies; and
mounting the selected one or more semiconductor assemblies on the substrate.

**9.** (Amended) The method of manufacturing the light emitting apparatus of Claim 8, wherein
in the step of mounting the selected one or more semiconductor assemblies on the substrate, the selected semiconductor assemblies are mounted on the substrate in a matrix arrangement such that a positional relation between the semiconductor light emitting device and a wire connection region of the submount in each semiconductor assembly is different from a positional relation between the semiconductor light emitting device and a wire connection region of the submount in any adjoining semiconductor assembly in the matrix arrangement.
